# EUROPEAN PATENT APPLICATION

(11) **EP 4 621 488 A1**
(43) Date of publication of application: **24.09.2025**
(21) Application number: 23891780.1
(22) Date of filing: 12.09.2023
(51) Int. Cl.: G03F 7/42, C11D 1/00, C11D 3/20, C11D 3/34, C11D 3/24, H01L 21/027

(54) **RINSE SOLUTION COMPOSITION FOR EXTREME ULTRAVIOLET PHOTOLITHOGRAPHY AND PATTERN FORMATION METHOD USING SAME**

(30) Priority: 18.11.2022 KR 20220155405
(71) Applicant: Ycchem Co., Ltd., Gyeongsangbuk-do 40046 (KR)
(72) Inventor: LEE, Su Jin, Daegu 42634 (KR); KIM, Gi Hong, Daegu 41808 (KR); LEE, Seung Hun, Daegu 42918 (KR); LEE, Seung Hyun, Daegu 42747 (KR)
(74) Representative: Ter Meer Steinmeister & Partner
(86) International application number: PCT/KR2023/013621
(87) International publication number: WO 2024/106711

(57) **Abstract**

The invention of the present application relates to a rinse solution composition for extreme ultraviolet photolithography and a pattern formation method using same. The rinse solution composition for extreme ultraviolet photolithography comprises: 0.0001-0.01 wt% of a fluorine-based surfactant; 0.0001-0.5 wt% of a pattern reinforcing agent which is a compound of chemical formula (1), a compound of chemical formula (2), or a mixture thereof; 0.0001-0.5 wt% of a substance selected from the group consisting of triol derivatives, tetraol derivatives, or mixtures thereof; and the remainder of water.

## Description

### Technical Field

The present disclosure relates to a rinse solution composition for improving a lifting defect level of a photoresist pattern during photolithography using extreme ultraviolet rays as a light source, and to a method of forming a photoresist pattern using the same.

### Background Art

In general, semiconductors are manufactured through a lithography process using as exposure light, ultraviolet rays with in a wavelength band of 193 nm, 248 nm, or 365 nm, and there is fierce competition among semiconductor manufacturers to reduce a minimum line width (hereinafter referred to as CD: critical dimension).

In order to form a finer pattern, a light source with a narrower wavelength band is required. Currently, lithography technology using extreme ultraviolet (EUV in a wavelength of 13.5 nm) as a light sources is actively used. A finer wavelength may be realized using this lithography technology.

However, since improvements have not been made to etching resistance of an EUV photoresist, a photoresist pattern with a high aspect ratio is constantly required. This causes pattern lifting defects to easily occur during development, resulting in a problem of significantly reducing a process margin in a manufacturing process.

Accordingly, there is a need to develop a technology for alleviating the level of lifting defects that occur during formation of a fine pattern. In order to improve photoresist performance, it may be the best way to alleviate a pattern lifting defect level. However, in reality, it is difficult to develop a novel photoresist that satisfies all performance aspects.

Aside from the need for developing novel photoresists, efforts are ongoing to alleviate the pattern lifting defect level in other ways.

### [Documents of Related Art]

(Patent Document 1) Korean Patent No. 10-2251232;
(Patent Document 2) Korean Patent No. 10-2100432;
(Patent Document 3) Korean Patent Application Publication No. 10-2016-0117305;
(Patent Document 4) Korean Patent No. 10-2080780;
(Patent Document 5) Korean Patent No. 10-1771177;

### Disclosure

### Technical Problem

An objective of the present disclosure is to provide a rinse solution composition for alleviating the level of pattern lifting defects in a pattern, the pattern lifting defects occurring after developing a photoresist, and to provide a method of forming a photoresist pattern, the method being capable of significantly reducing production costs by including a cleaning process using the rinse solution composition.

### Technical Solution

Various surfactants have been used in a water-based process solution composition that is used during a development process. However, in the present disclosure, an effective process solution composition may be prepared using a fluorine-based surfactant.

When a hydrocarbon-based surfactant with close hydrophobicity is used in a water-based process solution composition that mainly uses ultrapure water, a wall surface of a photoresist is induced to be hydrophobic, making it possible to reduce pattern melting and collapse. However, the hydrocarbon-based surfactant highly tends to agglomerate, thereby deteriorating uniformity in the properties of a rinse solution composition. Therefore, there is a possibility that the agglomerated hydrocarbon surfactant may cause defects during use of the rinse solution composition. That is, the use of the hydrocarbon-based surfactant requires an increase in its usage amount to reduce pattern melting. In this case, there is a concern that the photoresist may be damaged. In addition, when an excessive amount of unsuitable surfactant is used for the purpose of lowering surface tension of the rinse solution composition in order to reduce capillary force, it may cause pattern melting, which leads to pattern collapse.

In the present disclosure, a fluorine-based surfactant is used, and in addition, a pattern reinforcing agent which is a compound of Formula (1), a compound of Formula (2), or a mixture thereof, a substance selected from the group consisting of a triol derivative, a tetraol derivative, and a mixture thereof, and water are used. It was confirmed that the use of these materials achieved the excellent effect of alleviating a pattern lifting defect level.

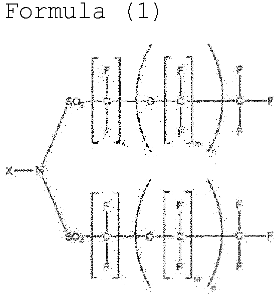

In Formula (1) above,
X is fluorine, hydrogen, or C₁ to C₅ alkyl,
X forms a single bond,
l is in the range of 1 to 4, and m and n are in the range of 1 to 3.

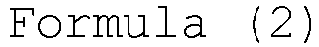

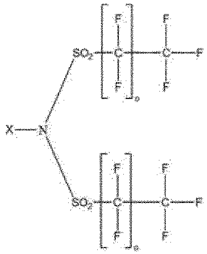

In Formula (2) above,
X is fluorine, hydrogen, or C₁ to C₅ alkyl,
X forms a single bond, and
O is in the range of 0 to 2.

As a representative developer that is currently used in most photolithography development processes, tetramethylammonium hydroxide diluted with pure water to a predetermined concentration is used (in most processes, a mixture of 2.38 wt% of tetramethylammonium hydroxide with 97.62 wt% of water is used).

It was found that pattern lifting defects occurred in the case where a photoresist pattern was successively cleaned with pure water alone after being developed in a photolithography process. In addition, it was also found that pattern collapse occurred in the case where a rinse solution composition containing tetramethylammonium hydroxide and pure water was successively applied after development or was applied continuously after the use of pure water.

In the case of the rinse solution composition containing tetramethylammonium hydroxide, it could be presumed that the pattern collapse occurred due to weakening of the exposed fine pattern and due to large or nonuniform capillary force.

Therefore, in order to reduce collapse of the exposed pattern and to reduce the line width roughness (NWR) and the number of defects in the photoresist pattern required in the process, it is necessary to conduct a study on a material that exerts a relatively weaker force on the exposed pattern than tetramethylammonium hydroxide.

In the present disclosure, a fluorine-based surfactant is used, and a pattern reinforcing agent which is a compound of Formula (1), a compound of Formula (2), or a mixture thereof, a substance selected from the group consisting of a triol derivative, a tetraol derivative, and a mixture thereof, and water are additionally used. By using these materials, it was confirmed that pattern collapse was prevented and the LWR and/or the number of defects was reduced.

According to a preferred first embodiment of the present disclosure, there is provided a rinse solution composition for alleviating a lifting defect level of a photoresist pattern during photoresist development, the rinse solution composition including: 0.0001 to 0.01 wt% of a fluorine-based surfactant; 0.0001 to 0.5 wt% of a pattern reinforcing agent which is a compound of Formula (1), a compound of Formula (2), or a mixture thereof; 0.0001 to 0.5 wt% of a substance selected from the group consisting of a triol derivative, a tetraol derivative, and a mixture thereof; and a residual amount of water.

In addition, according to a more preferred second embodiment of the present disclosure, there is provided a rinse solution composition for alleviating a lifting defect level of a photoresist pattern during photoresist development, the rinse solution composition including: 0.0001 to 0.01 wt% of a fluorine-based surfactant; 0.001 to 0.5 wt% of a pattern reinforcing agent which is a compound of Formula (1), a compound of Formula (2), or a mixture thereof; 0.0001 to 0.5 wt% of a substance selected from the group consisting of a triol derivative, a tetraol derivative, and a mixture thereof; and a residual amount of water.

Furthermore, according to a most preferred third embodiment of the present disclosure, there is provided a rinse solution composition for alleviating a lifting defect level of a photoresist pattern during photoresist development, the rinse solution composition including: 0.0001 to 0.01 wt% of a fluorine-based surfactant; 0.01 to 0.5 wt% of a pattern reinforcing agent which is a compound of Formula (1), a compound of Formula (2), or a mixture thereof; 0.0001 to 0.5 wt% of a substance selected from the group consisting of a triol derivative, a tetraol derivative, and a mixture thereof; and a residual amount of water.

In the embodiments, the fluorine-based surfactant may be selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorianted sulfonate, and mixtures thereof.

In the embodiments, the triol derivative may be a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof.

In the embodiments, the tetraol derivative may be a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

The present disclosure also provides a method of forming a photoresist pattern, the method including: (a) applying a photoresist to a semiconductor substrate to form a film; (b) exposing the photoresist film and then developing the photoresist film to form a pattern; and (c) cleaning the photoresist pattern with the rinse solution composition for alleviating the lifting defect level of the photoresist pattern.

The cause of pattern collapse is believed to be due to the capillary force that is generated between patterns when the pattern is cleaned with pure water after development, but the result of numerous long-term studies demonstrated that reducing only the capillary force could neither completely prevent pattern collapse and nor reduce the number of defects.

The excessive use of unsuitable surfactant for the purpose of lowering the surface tension of the rinse solution composition to reduce the capillary force may cause pattern melting, which leads to pattern lifting defects.

In order to alleviate the level of pattern lifting defects, it is important to select a surfactant that reduces the surface tension of the rinse solution composition and at the same time prevents melting of the photoresist pattern.

The rinse solution composition according to the present disclosure exhibits an excellent effect on photoresists, and particularly achieves the effect of alleviating the level of pattern lifting defects that occur during photoresist development.

### Advantageous Effects

A rinse solution composition according to the present disclosure has the effect of alleviating a lifting defect level of a pattern, the effect being unable to be achieved with a photoresist alone when forming a photoresist pattern. In particular, a method of forming a photoresist pattern including a cleaning process using the rinse solution composition has the effect of significantly reducing production costs.

### Description of Drawings

FIG. 1 shows the results of lifting evaluation for a photoresist pattern according to Example 1.
FIG. 2 shows the results of lifting evaluation for a photoresist pattern according to Comparative Example 1.

### Best Mode

Hereinafter, the present disclosure will be described in more detail.

The present disclosure, which is the result of numerous long-term studies, relates to "a rinse solution composition for alleviating a lifting defect level of a photoresist pattern, the rinse solution composition including: 0.0001 to 0.01 wt% of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorianted sulfonate, and mixtures thereof; 0.0001 to 0.5 wt% of a pattern reinforcing agent which is a compound of Formula (1), a compound of Formula (2), or a mixture thereof; 0.0001 to 0.5 wt% of a triol derivative alone, a tetraol derivative alone, or a mixture thereof, in which the triol derivative is a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the tetraol derivative is a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof; and a residual amount of water". Composition components of the rinse solution composition according to the present disclosure and a composition ratio therebetween were specified as shown in Examples 1 to 100. Composition components and a composition ratio that were in contrast with the above-mentioned composition components and composition ratio, respectively, were specified as shown in Comparative Examples 1 to 21.

Hereinafter, preferred examples of the present disclosure and comparative examples for comparison therewith will be described. However, the following examples are merely a preferred embodiment of the present disclosure, and the present disclosure is not limited to the following examples.

### Mode for Invention

### [Example 1]

A rinse solution composition for extreme ultraviolet photolithography for alleviating a collapse level of a photoresist pattern, the rinse solution composition including 0.001 wt% of fluoroacrylic carboxylate, 0.001 wt% of a fluoroimide-based compound of Formula (1), wherein l=1, m=1, and n=1, and 0.001 wt% of 1,2,3-propanetriol, was prepared by the following method.

0.001 wt% of fluoroacrylic carboxylate, 0.001 wt% of a fluoroimide-based compound of Formula (1), wherein l=1, m=1, and n=1, and 0.001 wt% of 1,2,3-propanetriol were added into a residual amount of distilled water, stirred for 6 hours, and passed through a 0.01 µm filter to remove fine solid impurities, thereby preparing a rinse solution composition for alleviating a defect level of a photoresist pattern.

### [Example 2 to Example 50]

Rinse solution compositions for alleviating a defect level of a photoresist pattern were prepared in the same manner as in Example 1 according to composition components and ratios that were specified as shown in Tables 1 to 12.

### [Example 51]

A rinse solution composition for extreme ultraviolet photolithography for alleviating a collapse level of a photoresist pattern, the rinse solution composition including 0.001 wt% of fluoroacrylic carboxylate, 0.001 wt% of a fluoroimide-based compound of Formula (2), wherein o=1, and 0.001 wt% of 1,2,3-propanetriol, was prepared by the following method.

0.001 wt% of fluoroacrylic carboxylate, 0.001 wt% of a fluoroimide-based compound of Formula (2), wherein o=1, and 0.001 wt% of 1,2,3-propanetriol were added into a residual amount of distilled water, stirred for 6 hours, and passed through a 0.01 µm filter to remove fine solid impurities, thereby preparing a rinse solution composition for alleviating a defect level of a photoresist pattern.

### [Example 52 to Example 100]

Rinse solution compositions for alleviating a defect level of a photoresist pattern were prepared in the same manner as in Example 51 according to composition components and ratios that were specified as shown in Tables 13 to 24.

### [Comparative Example 1]

Distilled water, which is generally used as the final cleaning solution in a development process during manufacture of a semiconductor device, was prepared.

### [Comparative Example 2 to Comparative Example 11]

For comparison with Examples, rinse solution compositions were prepared in the same manner as in Example 1, according to composition components and ratios that were specified as shown in Tables 1 to 12.

### [Comparative Example 12 to Comparative Example 21]

For comparison with Examples, rinse solution compositions were prepared in the same manner as in Example 51, according to composition components and ratios that were specified as shown in Tables 13 to 24.

### [Experimental Example 1 to Experimental Example 100 and Comparative Experimental Example 1 to Comparative Experimental Example 21]

A chemically amplified PHS acrylate hydrate hybrid EUV resist was spin-coated on a 12-inch silicon wafer (SK siltron) and soft-baked at 110°C for 60 seconds to form a resist film with a thickness of 40 nm. The resist film on the wafer was exposed to light through 18-nm (line:space=1:1) mask in an EUV exposure apparatus. The wafer was baked (PEB) at 110°C for 60 seconds. Then, the resist film was puddle-developed with a 2.38% tetramethylammonium hydroxide (TMAH) aqueous solution for 40 seconds. Deionized water (DI water) was poured into a puddle of developer on the wafer, the wafer was rotated while the pouring was continuing to replace the developer with the DI water, and the rotation of the wafer was stopped in a puddled state by the DI water. Subsequently, each of the rinse solution compositions of Examples 1 to 100 and Comparative Examples 2 to 21 was introduced into a puddle of DI water on the wafer, and the wafer was rotated at high speed to dry it.

At this time, pattern lifting defect level was measured for silicon wafers on which patterns were formed using the rinse solution compositions prepared in Examples 1 to 100 and Comparative Examples 1 to 21. The measurements are described as Experimental Examples 1 to 100 and Comparative Experimental Examples 1 to 21, and the results thereof are shown in Tables 25 and 26.

### (1) Verification of Pattern Lifting Prevention

After exposure energy was split, among 89 total blocks, the number of blocks in which a pattern did not collapse was measured using a critical dimension-scanning electron microscope (CD-SEM, Hitachi).

### (2) Transparency

Transparency of each of the prepared process solution compositions was checked with the naked eye and marked as transparent or opaque.

**TABLE 1**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 1 | Fluoro acryli c carbox ylate | 0.001 | Compou nd of Formul a (1), wherei n l=1, m=1, and n=1 | 0.001 | 1,2,3-propan etriol | 0.001 | Distil led water | 99.997 9 |
| Example 2 | Fluoro alkyl ether | 0.001 | Compound of Formul a (1), wherei n l=1, m=1, and n=1 | 0.001 | 1,2,3-propan etriol | 0.001 | Distilled water | 99.997 9 |
| Example 3 | Fluoro alkyle ne ether | 0.001 | Compou nd of Formul a (1), wherei n l=1, m=1, and n=1 | 0.001 | 1,2,3-propan etriol | 0.001 | Distil led water | 99.997 9 |
| Example 4 | Fluoro alkyl sulfat e | 0.001 | Compou nd of Formul a (1), wherei n l=1, m=1, and n=1 | 0.001 | 1,2,3-propan etriol | 0.001 | Distil led water | 99.997 9 |
| Example 5 | Fluoro alkyl phosph ate | 0.001 | Compou nd of Formul a (1), wherei n l=1, m=1, and n=1 | 0.001 | 1,2,3-propanetriol | 0.001 | Distil led water | 99.997 9 |
| Example 6 | Fluoro acryl co-polyme r | 0.001 | Compou nd of Formul a (1), wherei n l=1, m=1, and n=1 | 0.001 | 1,2,3-propan etriol | 0.001 | Distil led water | 99.997 9 |
| Example 7 | Fluoro co-polyme r | 0.001 | Compou nd of Formul a (1), wherei n l=1, m=1, and n=1 | 0.001 | 1,2,3-propan etriol | 0.001 | Distil led water | 99.997 9 |
| Example 8 | Perflu orinat ed acid | 0.001 | Compou nd of Formula (1), wherei n l=1, m=1, and n=1 | 0.001 | 1,2,3-propan etriol | 0.001 | Distil led water | 99.997 9 |
| Example 9 | Perflu orinat ed carbox ylate | 0.001 | Compou nd of Formul a (1), wherei n l=1, m=1, and n=1 | 0.001 | 1,2,3-propan etriol | 0.001 | Distil led water | 99.997 9 |
| Example 10 | Perflu oriant ed sulfon ate | 0.001 | Compou nd of Formul a (1), wherei n l=1, m=1, and n=1 | 0.001 | 1,2,3-propan etriol | 0.001 | Distil led water | 99.997 9 |
| Compara tive Example 1 | - | - | | | - | - | Distil led water | 100 |

**TABLE 2**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 11 | Fluoro acryli c carbox ylate | 0.001 | Compou nd of Formul a (1), wherei n l=1, m=1, and n=1 | 0.001 | 1, 2, 3, 4-butane tetrao l | 0.001 | Distil led water | 99.997 9 |
| Example 12 | Fluoro alkyl ether | 0.001 | Compou nd of Formul a (1), wherei n l=1, m=1, and n=1 | 0.001 | 1, 2, 3, 4-butane tetrao l | 0.001 | Distil led water | 99.997 9 |
| Example 13 | Fluoro alkyle ne ether | 0.001 | Compou nd of Formula (1), wherei n l=1, m=1, and n=1 | 0.001 | 1, 2, 3, 4-butane tetrao l | 0.001 | Distil led water | 99.997 9 |
| Example 14 | Fluoro alkyl sulfat e | 0.001 | Compou nd of Formul a (1), wherei n l=1, m=1, and n=1 | 0.001 | 1, 2, 3, 4-butane tetrao l | 0.001 | Distil led water | 99.997 9 |
| Example 15 | Fluoro alkyl phosph ate | 0.001 | Compou nd of Formul a (1), wherei n l=1, m=1, and n=1 | 0.001 | 1, 2, 3, 4-butane tetrao l | 0.001 | Distil led water | 99.997 9 |
| Example 16 | Fluoro acryl co-polymer | 0.001 | Compou nd of Formul a (1), wherei n l=1, m=1, and n=1 | 0.001 | 1, 2, 3, 4-butane tetraol | 0.001 | Distil led water | 99.997 9 |
| Example 17 | Fluoro co-polyme r | 0.001 | Compou nd of Formul a (1), wherei n l=1, m=1, and n=1 | 0.001 | 1, 2, 3, 4-butane tetrao l | 0.001 | Distil led water | 99.997 9 |
| Example 18 | Perflu orinat ed acid | 0.001 | Compou nd of Formul a (1), wherei n l=1, m=1, and n=1 | 0.001 | 1, 2, 3, 4-butane tetrao l | 0.001 | Distil led water | 99.997 9 |
| Example 19 | Perflu orinat ed carbox ylate | 0.001 | Compou nd of Formul a (1), wherein l=1, m=1, and n=1 | 0.001 | 1, 2, 3, 4-butane tetrao l | 0.001 | Distil led water | 99.997 9 |
| Example 20 | Perflu oriant ed sulfon ate | 0.001 | Compou nd of Formul a (1), wherei n l=1, m=1, and n=1 | 0.001 | 1, 2, 3, 4-butane tetrao l | 0.001 | Distil led water | 99.997 9 |

**TABLE 3**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 21 | Fluoro acryli c carbox ylate | 0.001 | Compou nd of Formul a (1), wherei n l=1, m=1, and n=1 | 0.0001 | 1,2,3-propan etriol | 0.001 | Distil led water | 99.997 9 |
| Example 1 | Fluoro acryli c carbox ylate | 0.001 | Compou nd of Formul a (1), wherei n l=1, m=1, and n=1 | 0.001 | 1,2,3-propan etriol | 0.001 | Distil led water | 99.997 0 |
| Example 22 | Fluoro acryli c carbox ylate | 0.001 | Compou nd of Formul a (1), wherei n l=1, m=1, and n=1 | 0.01 | 1,2,3-propan etriol | 0.001 | Distil led water | 99.988 0 |
| Example 23 | Fluoro acryli c carbox ylate | 0.001 | Compou nd of Formul a (1), wherei n l=1, m=1, and n=1 | 0.5 | 1,2,3-propan etriol | 0.001 | Distil led water | 99.498 0 |
| Compara tive Example 2 | Fluoro acryli c carbox ylate | 0.001 | Compou nd of Formul a (1), wherei n l=1, m=1, and n=1 | 1.0 | 1,2,3-propan etriol | 0.001 | Distil led water | 98.998 0 |

**TABLE 4**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 24 | Fluoro alkyl ether | 0.001 | Compou nd of Formul a (1), wherei n l=1, m=1, and n=1 | 0.0001 | 1,2,3-propan etriol | 0.001 | Distil led water | 99.997 9 |
| Example 2 | Fluoro alkyl ether | 0.001 | Compou nd of Formula (1), wherei n l=1, m=1, and n=1 | 0.001 | 1,2,3-propan etriol | 0.001 | Distil led water | 99.997 0 |
| Example 25 | Fluoro alkyl ether | 0.001 | Compou nd of Formul a (1), wherei n l=1, m=1, and n=1 | 0.01 | 1,2,3-propan etriol | 0.001 | Distil led water | 99.988 0 |
| Example 26 | Fluoro alkyl ether | 0.001 | Compou nd of Formul a (1), wherei n l=1, m=1, and n=1 | 0.5 | 1,2,3-propan etriol | 0.001 | Distil led water | 99.498 0 |
| Compara tive Example 3 | Fluoro alkyl ether | 0.001 | Compou nd of Formul a (1), wherei n l=1, m=1, and n=1 | 1.0 | 1,2,3-propan etriol | 0.001 | Distil led water | 98.998 0 |

**TABLE 5**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 27 | Fluoro alkyle ne ether | 0.001 | Compou nd of Formul a (1), wherei n l=1, m=1, and n=1 | 0.0001 | 1,2,3-propan etriol | 0.001 | Distil led water | 99.997 9 |
| Example 3 | Fluoro alkyle ne ether | 0.001 | Compou nd of Formul a (1), wherei n l=1, m=1, and n=1 | 0.001 | 1,2,3-propan etriol | 0.001 | Distil led water | 99.997 0 |
| Example 28 | Fluoro alkyle ne ether | 0.001 | Compou nd of Formul a (1), wherei n l=1, m=1, and n=1 | 0.01 | 1,2,3-propan etriol | 0.001 | Distil ed water | 99.988 0 |
| Example 29 | Fluoro alkyle ne ether | 0.001 | Compou nd of Formu la (1), wherein l=1, m=1, and n=1 | 0.5 | 1,2,3-propan etriol | 0.001 | Distil led water | 99.498 0 |
| Compara tive Example 4 | Fluoro alkyle ne ether | 0.001 | Compou nd of Formul a (1), wherei n l=1, m=1, and n=1 | 1.0 | 1,2,3-propan etriol | 0.001 | Distil led water | 98.998 0 |

**TABLE 6**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 30 | Fluoro alkyl sulfat e | 0.001 | Compou nd of Formul a (1), wherei n l=1, m=1, and n=1 | 0.0001 | 1,2,3-propan etriol | 0.001 | Distil led water | 99.997 9 |
| Example 4 | Fluoro alkyl sulfat e | 0.001 | Compou nd of Formul a (1), wherei n l=1, m=1, and n=1 | 0.001 | 1,2,3-propan etriol | 0.001 | Distil led water | 99.997 0 |
| Example 31 | Fluoro alkyl sulfat e | 0.001 | Formul a (1), wherei n l=1, m=1, and n=1 | 0.01 | 1,2,3-propanetriol | 0.001 | Distil led water | 99.988 0 |
| Example 32 | Fluoro alkyl sulfat e | 0.001 | Compou nd of Formul a (1), wherei n l=1, m=1, and n=1 | 0.5 | 1,2,3-propan etriol | 0.001 | Distil led water | 99.498 0 |
| Compara tive Example 5 | Fluoro alkyl sulfat e | 0.001 | Compou nd of Formul a (1), wherei n l=1, m=1, and n=1 | 1.0 | 1,2,3-propan etriol | 0.001 | Distil led water | 98.998 0 |

**TABLE 7**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 33 | Fluoro alkyl phosph ate | 0.001 | Compou nd of Formul a (1), wherei n l=1, m=1, and n=1 | 0.0001 | 1,2,3-propan etriol | 0.001 | Distil led water | 99.997 9 |
| Example 5 | Fluoro alkyl phosph ate | 0.001 | Compou nd of Formul a (1), wherei n l=1, m=1, and n=1 | 0.001 | 1,2,3-propan etriol | 0.001 | Distil led water | 99.997 0 |
| Example 34 | Fluoro alkyl phosph ate | 0.001 | Compou nd of Formul a (1), wherei n l=1, m=1, and n=1 | 0.01 | 1,2,3-propan etriol | 0.001 | Distil led water | 99.988 0 |
| Example 35 | Fluoro alkyl phosph ate | 0.001 | Compou nd of Formul a (1), wherei n l=1, m=1, and n=1 | 0.5 | 1,2,3-propan etriol | 0.001 | Distil led water | 99.498 0 |
| Compara tive Example 6 | Fluoro alkyl phosph ate | 0.001 | Compou nd of Formul a (1), wherei n l=1, m=1, and n=1 | 1.0 | 1,2,3-propan etriol | 0.001 | Distil led water | 98.998 0 |

**TABLE 8**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 36 | Fluoro acryl co-polyme r | 0.001 | Compound of Formul a (1), wherei n l=1, m=1, and n=1 | 0.0001 | 1,2,3-propan etriol | 0.001 | Distilled water | 99.997 9 |
| Example 6 | Fluoro acryl co-polyme r | 0.001 | Compou nd of Formul a (1), wherei n l=1, m=1, and n=1 | 0.001 | 1,2,3-propan etriol | 0.001 | Distil led water | 99.997 0 |
| Example 37 | Fluoro acryl co-polyme r | 0.001 | Compou nd of Formul a (1), wherei n l=1, m=1, and n=1 | 0.01 | 1,2,3-propan etriol | 0.001 | Distil led water | 99.988 0 |
| Example 38 | Fluoro acryl co-polyme r | 0.001 | Compou nd of Formul a (1), wherei n l=1, m=1, and n=1 | 0.5 | 1,2,3-propanetriol | 0.001 | Distil led water | 99.498 0 |
| Compara tive Example 7 | Fluoro acryl co-polyme r | 0.001 | Compou nd of Formul a (1), wherei n l=1, m=1, and n=1 | 1.0 | 1,2,3-propan etriol | 0.001 | Distil led water | 98.998 0 |

**TABLE 9**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 39 | Fluoro co-polyme r | 0.001 | Compou nd of Formul a (1), wherein l=1, m=1, and n=1 | 0.0001 | 1,2,3-propan etriol | 0.001 | Distil led water | 99.997 9 |
| Example 7 | Fluoro co-polyme r | 0.001 | Compou nd of Formul a (1), wherei n l=1, m=1, and n=1 | 0.001 | 1,2,3-propan etriol | 0.001 | Distil led water | 99.997 0 |
| Example 40 | Fluoro co-polyme r | 0.001 | Compou nd of Formul a (1), wherei n l=1, m=1, and n=1 | 0.01 | 1,2,3-propan etriol | 0.001 | Distil led water | 99.988 0 |
| Example 41 | Fluoro co-polyme r | 0.001 | Compou nd of Formul a (1), wherei n l=1, m=1, and n=1 | 0.5 | 1,2,3-propan etriol | 0.001 | Distil led water | 99.498 0 |
| Compara tive Example 8 | Fluoro co-polyme r | 0.001 | Compou nd of Formul a (1), wherei n l=1, m=1, and n=1 | 1.0 | 1,2,3-propan etriol | 0.001 | Distil led water | 98.998 0 |

**TABLE 10**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 42 | Perflu orinat ed acid | 0.001 | Compou nd of Formul a (1), wherei n l=1, m=1, and n=1 | 0.0001 | 1,2,3-propan etriol | 0.001 | Distil led water | 99.997 9 |
| Example 8 | Perflu orinat ed acid | 0.001 | Compou nd of Formul a (1), wherei n l=1, m=1, and n=1 | 0.001 | 1,2,3-propan etriol | 0.001 | Distil led water | 99.997 0 |
| Example 43 | Perflu orinat ed acid | 0.001 | Compou nd of Formul a (1), wherei n l=1, m=1, and n=1 | 0.01 | 1,2,3-propan etriol | 0.001 | Distil led water | 99.988 0 |
| Example 44 | Perflu orinat ed acid | 0.001 | Compou nd of Formul a (1), wherei n l=1, m=1, and n=1 | 0.5 | 1,2,3-propan etriol | 0.001 | Distil led water | 99.498 0 |
| Comparative Example 9 | Perfluorinat ed acid | 0.001 | Compound of Formul a (1), wherei n l=1, m=1, and n=1 | 1.0 | 1,2,3-propan etriol | 0.001 | Distilled water | 98.998 0 |

**TABLE 11**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 45 | Perflu orinat ed carbox ylate | 0.001 | Compou nd of Formul a (1), wherei n l=1, m=1, and n=1 | 0.0001 | 1,2,3-propan etriol | 0.001 | Distil led water | 99.997 9 |
| Example 9 | Perflu orinat ed carboxylate | 0.001 | Compou nd of Formul a (1), wherei n l=1, m=1, and n=1 | 0.001 | 1,2,3-propan etriol | 0.001 | Distil led water | 99.997 0 |
| Example 46 | Perflu orinat ed carbox ylate | 0.001 | Compou nd of Formul a (1), wherei n l=1, m=1, and n=1 | 0.01 | 1,2,3-propan etriol | 0.001 | Distil led water | 99.988 0 |
| Example 47 | Perflu orinat ed carbox ylate | 0.001 | Compou nd of Formul a (1), wherei n l=1, m=1, and n=1 | 0.5 | 1,2,3-propan etriol | 0.001 | Distil led water | 99.498 0 |
| Compara tive Example 10 | Perflu orinat ed carbox ylate | 0.001 | Compou nd of Formul a (1), wherein l=1, m=1, and n=1 | 1.0 | 1,2,3-propan etriol | 0.001 | Distil led water | 98.998 0 |

**TABLE 12**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 48 | Perflu orianted sulfonate | 0.001 | Compound of Formula (1), wherein l=1, m=1, and n=1 | 0.0001 | 1,2,3-propan etriol | 0.001 | Distilled water | 99.9979 |
| Example 10 | Perflu orianted sulfonate | 0.001 | Compound of Formula (1), wherein l=1, m=1, and n=1 | 0.001 | 1,2,3-propan etriol | 0.001 | Distiled water | 99.9970 |
| Example 49 | Perflu orianted sulfonate | 0.001 | Compound of Formula (1), wherein l=1, m=1, and n=1 | 0.01 | 1,2,3-propan etriol | 0.001 | Distilled water | 99.988 0 |
| Example 50 | Perflu orianted sulfonate | 0.001 | Compou nd of Formula (1), wherei n l=1, m=1, and n=1 | 0.5 | 1,2,3-propan etriol | 0.001 | Distilled water | 99.498 0 |
| Compara tive Example 11 | Perflu orianted sulfonate | 0.001 | Compound of Formula (1), wherein l=1, m=1, and n=1 | 1.0 | 1,2,3-propan etriol | 0.001 | Distilled water | 98.998 0 |

**TABLE 13**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 51 | Fluoro acrylic carbox ylate | 0.001 | Compou nd of Formul a (2), wherei n o=1 | 0.001 | 1,2,3-propan etriol | 0.001 | Distil led water | 99.997 9 |
| Example 52 | Fluoro alkyl ether | 0.001 | Compou nd of Formul a (2), wherei n o=1 | 0.001 | 1,2,3-propan etriol | 0.001 | Distil led water | 99.997 9 |
| Example 53 | Fluoro alkyle ne ether | 0.001 | Compou nd of Formul a (2), wherei n o=1 | 0.001 | 1,2,3-propan etriol | 0.001 | Distil led water | 99.997 9 |
| Example 54 | Fluoro alkyl sulfate | 0.001 | Compou nd of Formula (2), wherei n o=1 | 0.001 | 1,2,3-propan etriol | 0.001 | Distil led water | 99.997 9 |
| Example 55 | Fluoro alkyl phosph ate | 0.001 | Compou nd of Formul a (2), wherei n o=1 | 0.001 | 1,2,3-propan etriol | 0.001 | Distilled water | 99.997 9 |
| Example 56 | Fluoro acryl co-polyme r | 0.001 | Compou nd of Formul a (2), wherei n o=1 | 0.001 | 1,2,3-propan etriol | 0.001 | Distil led water | 99.997 9 |
| Example 57 | Fluoro co-polyme r | 0.001 | Compou nd of Formul a (2), wherei n o=1 | 0.001 | 1,2,3-propan etriol | 0.001 | Distil led water | 99.997 9 |
| Example 58 | Perflu orinat ed acid | 0.001 | Compou nd of Formul a (2), wherei n o=1 | 0.001 | 1,2,3-propan etriol | 0.001 | Distil led water | 99.997 9 |
| Example 59 | Perflu orinated carbox ylate | 0.001 | Compoind of Formula (2), wherei n o=1 | 0.001 | 1,2,3-propan etriol | 0.001 | Distilled water | 99.9979 |
| Example 60 | Perflu orianted sulfon ate | 0.001 | Compound of Formula (2), wherein o=1 | 0.001 | 1,2,3-propan etriol | 0.001 | Distilled water | 99.9979 |
| Comparative Example 1 | - | - | | | - | - | Distilled water | 100 |

**TABLE 14**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 61 | Fluoro acrylic carbox ylate | 0.001 | Compound of Formula (2), wherein o=1 | 0.001 | 1, 2, 3, 4-butane tetraol | 0.001 | Distilled water | 99.9979 |
| Example 62 | Fluoro alkyl ether | 0.001 | Compou nd of Formul a (2), wherei n o=1 | 0.001 | 1, 2, 3, 4-butane tetraol | 0.001 | Distil led water | 99.997 9 |
| Example 63 | Fluoro alkyle ne ether | 0.001 | Compou nd of Formul a (2), wherei n o=1 | 0.001 | 1, 2, 3, 4-butane tetraol | 0.001 | Distil led water | 99.997 9 |
| Example 64 | Fluoro alkyl sulfat e | 0.001 | Compou nd of Formul a (2), wherei n o=1 | 0.001 | 1, 2, 3, 4-butane tetraol | 0.001 | Distil led water | 99.997 9 |
| Example 65 | Fluoro alkyl phosph ate | 0.001 | Compou nd of Formul a (2), wherei n o=1 | 0.001 | 1, 2, 3, 4-butane tetraol | 0.001 | Distil led water | 99.997 9 |
| Example 66 | Fluoro acryl co-polyme r | 0.001 | Compou nd of Formul a (2), wherei n o=1 | 0.001 | 1, 2, 3, 4-butane tetrao l | 0.001 | Distil led water | 99.997 9 |
| Example 67 | Fluoro co-polyme r | 0.001 | Compou nd of Formul a (2), wherei n o=1 | 0.001 | 1, 2, 3, 4-butane tetrao l | 0.001 | Distil led water | 99.997 9 |
| Example 68 | Perflu orinat ed acid | 0.001 | Compou nd of Formul a (2), wherei n o=1 | 0.001 | 1, 2, 3, 4-butane tetrao l | 0.001 | Distil led water | 99.997 9 |
| Example 69 | Perflu orinat ed carbox ylate | 0.001 | Compou nd of Formul a (2), wherei n o=1 | 0.001 | 1, 2, 3, 4-butane tetrao l | 0.001 | Distil led water | 99.997 9 |
| Example 70 | Perflu oriant ed sulfon ate | 0.001 | Compou nd of Formul a (2), wherei n o=1 | 0.001 | 1, 2, 3, 4-butane tetrao l | 0.001 | Distil led water | 99.997 9 |

**TABLE 15**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 71 | Fluoro acryli c carbox ylate | 0.001 | Compou nd of Formul a (2), wherei n o=1 | 0.0001 | 1,2,3-propan etriol | 0.001 | Distil led water | 99.997 9 |
| Example 51 | Fluoro acryli c carbox ylate | 0.001 | Compou nd of Formul a (2), wherei n o=1 | 0.001 | 1,2,3-propan etriol | 0.001 | Distil led water | 99.997 0 |
| Example 72 | Fluoro acryli c carbox ylate | 0.001 | Compou nd of Formul a (2), wherei n o=1 | 0.01 | 1,2,3-propan etriol | 0.001 | Distil led water | 99.988 0 |
| Example 73 | Fluoro acryli c carbox ylate | 0.001 | Compou nd of Formula (2), wherei n o=1 | 0.5 | 1,2,3-propan etriol | 0.001 | Distil led water | 99.498 0 |
| Compara tive Example 12 | Fluoro acryli c carbox ylate | 0.001 | Compou nd of Formul a (2), wherei n o=1 | 1.0 | 1,2,3-propan etriol | 0.001 | Disti lled water | 98.998 0 |

**TABLE 16**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 74 | Fluoro alkyl ether | 0.001 | Compou nd of Formul a (2), wherei n o=1 | 0.0001 | 1,2,3-propan etriol | 0.001 | Distil led water | 99.997 9 |
| Example 52 | Fluoro alkyl ether | 0.001 | Compou nd of Formul a (2), wherein o=1 | 0.001 | 1,2,3-propan etriol | 0.001 | Distil led water | 99.997 0 |
| Example 75 | Fluoro alkyl ether | 0.001 | Compou nd of Formul a (2), wherei n o=1 | 0.01 | 1,2,3-propan etriol | 0.001 | Distil led water | 99.988 0 |
| Example 76 | Fluoro alkyl ether | 0.001 | Compou nd of Formul a (2), wherei n o=1 | 0.5 | 1,2,3-propan etriol | 0.001 | Distil led water | 99.498 0 |
| Compara tive Example 13 | Fluoro alkyl ether | 0.001 | Compou nd of Formul a (2), wherei n o=1 | 1.0 | 1,2,3-propan etriol | 0.001 | Distil led water | 98.998 0 |

**TABLE 17**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 77 | Fluoro alkylene ether | 0.001 | Compou nd of Formul a (2), wherei n o=1 | 0.0001 | 1,2,3-propanetriol | 0.001 | Distil led water | 99.997 9 |
| Example 53 | Fluoro alkyle ne ether | 0.001 | Compou nd of Formul a (2), wherei n o=1 | 0.001 | 1,2,3-propan etriol | 0.001 | Distil led water | 99.997 0 |
| Example 78 | Fluoro alkyle ne ether | 0.001 | Compou nd of Formul a (2), wherei n o=1 | 0.01 | 1,2,3-propan etriol | 0.001 | Distil led water | 99.988 0 |
| Example 79 | Fluoro alkyle ne ether | 0.001 | Compou nd of Formul a (2), wherei n o=1 | 0.5 | 1,2,3-propan etriol | 0.001 | Distil led water | 99.498 0 |
| Compara tive Example 14 | Fluoro alkyle ne ether | 0.001 | Compou nd of Formul a (2), wherei n o=1 | 1.0 | 1,2,3-propan etriol | 0.001 | Distil led water | 98.998 0 |

**TABLE 18**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 80 | Fluoro alkyl sulfat e | 0.001 | Compou nd of Formul a (2), wherei n o=1 | 0.0001 | 1,2,3-propan etriol | 0.001 | Distil led water | 99.997 9 |
| Example 54 | Fluoro alkyl sulfat e | 0.001 | Compou nd of Formul a (2), wherei n o=1 | 0.001 | 1,2,3-propan etriol | 0.001 | Distil led water | 99.997 0 |
| Example 81 | Fluoro alkyl sulfat e | 0.001 | Compou nd of Formul a (2), wherei n o=1 | 0.01 | 1,2,3-propan etriol | 0.001 | Distil led water | 99.988 0 |
| Example 82 | Fluoro alkyl sulfate | 0.001 | Compou nd of Formula (2), wherei n o=1 | 0.5 | 1,2,3-propan etriol | 0.001 | Distil led water | 99.498 0 |
| Compara tive Example 15 | Fluoro alkyl sulfat e | 0.001 | Compou nd of Formul a (2), wherei n o=1 | 1.0 | 1,2,3-propan etriol | 0.001 | Distil led water | 98.998 0 |

**TABLE 19**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 83 | Fluoro alkyl phosph ate | 0.001 | Compou nd of Formul a (2), wherei n o=1 | 0.0001 | 1,2,3-propan etriol | 0.001 | Distil led water | 99.997 9 |
| Example 55 | Fluoro alkyl phosph ate | 0.001 | Compou nd of Formul a (2), wherei n o=1 | 0.001 | 1,2,3-propan etriol | 0.001 | Distil led water | 99.997 0 |
| Example 84 | Fluoro alkyl phosph ate | 0.001 | Compou nd of Formul a (2), wherei n o=1 | 0.01 | 1,2,3-propan etriol | 0.001 | Distil led water | 99.988 0 |
| Example 85 | Fluoro alkyl phosph ate | 0.001 | Compou nd of Formul a (2), wherei n o=1 | 0.5 | 1,2,3-propan etriol | 0.001 | Distil led water | 99.498 0 |
| Compara tive Example 16 | Fluoro alkyl phosph ate | 0.001 | Compou nd of Formul a (2), wherei n o=1 | 1.0 | 1,2,3-propan etriol | 0.001 | Distil led water | 98.998 0 |

**TABLE 20**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 86 | Fluoro acryl co-polyme r | 0.001 | Compou nd of Formula (2), wherei n o=1 | 0.0001 | 1,2,3-propan etriol | 0.001 | Distil led water | 99.997 9 |
| Example 56 | Fluoro acryl co-polyme r | 0.001 | Compou nd of Formul a (2), wherei n o=1 | 0.001 | 1,2,3-propan etriol | 0.001 | Distil led water | 99.997 0 |
| Example 87 | Fluoro acryl co-polyme r | 0.001 | Compou nd of Formul a (2), wherei n o=1 | 0.01 | 1,2,3-propan etriol | 0.001 | Distil led water | 99.988 0 |
| Example 88 | Fluoro acryl co-polyme r | 0.001 | Compou nd of Formul a (2), wherei n o=1 | 0.5 | 1,2,3-propan etriol | 0.001 | Distil led water | 99.498 0 |
| Compara tive Example 17 | Fluoro acryl co-polyme r | 0.001 | Compou nd of Formul a (2), wherei n o=1 | 1.0 | 1,2,3-propan etriol | 0.001 | Distil led water | 98.998 0 |

**TABLE 21**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 89 | Fluoro co-polyme r | 0.001 | Compou nd of Formul a (2), wherei n o=1 | 0.0001 | 1,2,3-propan etriol | 0.001 | Distil led water | 99.997 9 |
| Example 57 | Fluoro co-polym er | 0.001 | Compou nd of Formul a (2), wherei n o=1 | 0.001 | 1,2,3-propan etriol | 0.001 | Distil led water | 99.997 0 |
| Example 90 | Fluoro co-polyme r | 0.001 | Compou nd of Formul a (2), wherei n o=1 | 0.01 | 1,2,3-propan etriol | 0.001 | Distil led water | 99.988 0 |
| Example 91 | Fluoro co-polyme r | 0.001 | Compou nd of Formul a (2), wherei n o=1 | 0.5 | 1,2,3-propan etriol | 0.001 | Distil led water | 99.498 0 |
| Compara tive Example 18 | Fluoro co-polyme r | 0.001 | Compou nd of Formul a (2), wherei n o=1 | 1.0 | 1,2,3-propan etriol | 0.001 | Distil led water | 98.998 0 |

**TABLE 22**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 92 | Perflu orinat ed acid | 0.001 | Compou nd of Formul a (2), wherei n o=1 | 0.0001 | 1,2,3-propan etriol | 0.001 | Distil led water | 99.997 9 |
| Example 58 | Perflu orinat ed acid | 0.001 | Compou nd of Formul a (2), wherei n o=1 | 0.001 | 1,2,3-propan etriol | 0.001 | Distil led water | 99.997 0 |
| Example 93 | Perfluorinat ed acid | 0.001 | Compound of Formul a (2), wherei n o=1 | 0.01 | 1,2,3-propan etriol | 0.001 | Distilled water | 99.988 0 |
| Example 94 | Perflu orinat ed acid | 0.001 | Compou nd of Formul a (2), wherei n o=1 | 0.5 | 1,2,3-propan etriol | 0.001 | Distil led water | 99.498 0 |
| Compara tive Example 19 | Perflu orinat ed acid | 0.001 | Compou nd of Formul a (2), wherei n o=1 | 1.0 | 1,2,3-propan etriol | 0.001 | Distil led water | 98.998 0 |

**TABLE 23**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 95 | Perflu orinat ed carboxylate | 0.001 | Compou nd of Formul a (2), wherei n o=1 | 0.0001 | 1,2,3-propan etriol | 0.001 | Distil led water | 99.997 9 |
| Example 59 | Perflu orinat ed carbox ylate | 0.001 | Compou nd of Formul a (2), wherei n o=1 | 0.001 | 1,2,3-propan etriol | 0.001 | Distil led water | 99.997 0 |
| Example 96 | Perflu orinat ed carbox ylate | 0.001 | Compou nd of Formul a (2), wherei n o=1 | 0.01 | 1,2,3-propan etriol | 0.001 | Distil led water | 99.988 0 |
| Example 97 | Perflu orinat ed carbox ylate | 0.001 | Compou nd of Formul a (2), wherei n o=1 | 0.5 | 1,2,3-propan etriol | 0.001 | Distil led water | 99.498 0 |
| Compara tive Example 20 | Perflu orinat ed carbox ylate | 0.001 | Compou nd of Formul a (2), wherei n o=1 | 1.0 | 1,2,3-propan etriol | 0.001 | Distil led water | 98.998 0 |

**TABLE 24**

| | Surfactant | | Pattern reinforcing agent | | Additive | | Distilled water | |
|---|---|---|---|---|---|---|---|---|
| | Name | Amount (wt%) | Name | Amount (wt%) | Name | Amount (wt%) | Name | Amount (wt%) |
| Example 98 | Perflu oriant ed sulfon ate | 0.001 | Compou nd of Formul a (2), wherei n o=1 | 0.0001 | 1,2,3-propan etriol | 0.001 | Distil led water | 99.99 79 |
| Example 60 | Perflu oriant ed sulfon ate | 0.001 | Compou nd of Formul a (2), wherei n o=1 | 0.001 | 1,2,3-propan etriol | 0.001 | Distil led water | 99.9970 |
| Example 99 | Perflu oriant ed sulfon ate | 0.001 | Compou nd of Formul a (2), wherei n o=1 | 0.01 | 1,2,3-propan etriol | 0.001 | Distil led water | 99.988 0 |
| Example 100 | Perflu oriant ed sulfonate | 0.001 | Compou nd of Formul a (2), wherei n o=1 | 0.5 | 1,2,3-propan etriol | 0.001 | Distil led water | 99.498 0 |
| Compara tive Example 21 | Perflu oriant ed sulfon ate | 0.001 | Compou nd of Formul a (2), wherei n o=1 | 1.0 | 1,2,3-propan etriol | 0.001 | Distil led water | 98.998 0 |

### [Experimental Example 1 to Experimental Example 100 and Comparative Experimental Example 1 to Comparative Experimental Example 21]

Pattern lifting defect level and transparency were measured for silicon wafers on which patterns were formed using the rinse solution compositions prepared in Examples 1 to 100 and Comparative Examples 1 to 21. The measurements are described as Experimental Examples 1 to 100 and Comparative Experimental Examples 1 to 21, and the results thereof are shown in Tables 25 and 26.

### (1) Evaluation of Pattern Lifting Defect Level

After exposure energy was split, among 89 total blocks, the number of blocks in which a pattern did not collapse was measured using a critical dimension-scanning electron microscope (CD-SEM, Hitachi).

### (2) Evaluation of Transparency

Transparency of each of the prepared rinse solution compositions was checked with the naked eye and marked as transparent or opaque.

**TABLE 25**

| | Number of blocks with no pattern lifting defect | Transparency |
|---|---|---|
| Experimental Example 1 | 58 | Transparent |
| Experimental Example 2 | 58 | Transparent |
| Experimental Example 3 | 58 | Transparent |
| Experimental Example 4 | 57 | Transparent |
| Experimental Example 5 | 57 | Transparent |
| Experimental Example 6 | 56 | Transparent |
| Experimental Example 7 | 56 | Transparent |
| Experimental Example 8 | 55 | Transparent |
| Experimental Example 9 | 54 | Transparent |
| Experimental Example 10 | 54 | Transparent |
| Experimental Example 11 | 58 | Transparent |
| Experimental Example 12 | 58 | Transparent |
| Experimental Example 13 | 57 | Transparent |
| Experimental Example 14 | 57 | Transparent |
| Experimental Example 15 | 56 | Transparent |
| Experimental Example 16 | 55 | Transparent |
| Experimental Example 17 | 55 | Transparent |
| Experimental Example 18 | 54 | Transparent |
| Experimental Example 19 | 54 | Transparent |
| Experimental Example 20 | 54 | Transparent |
| Experimental Example 21 | 57 | Transparent |
| Experimental Example 22 | 58 | Transparent |
| Experimental Example 23 | 57 | Transparent |
| Experimental Example 24 | 57 | Transparent |
| Experimental Example 25 | 58 | Transparent |
| Experimental Example 26 | 57 | Transparent |
| Experimental Example 27 | 56 | Transparent |
| Experimental Example 28 | 58 | Transparent |
| Experimental Example 29 | 57 | Transparent |
| Experimental Example 30 | 56 | Transparent |
| Experimental Example 31 | 57 | Transparent |
| Experimental Example 32 | 56 | Transparent |
| Experimental Example 33 | 56 | Transparent |
| Experimental Example 34 | 57 | Transparent |
| Experimental Example 35 | 56 | Transparent |
| Experimental Example 36 | 55 | Transparent |
| Experimental Example 37 | 56 | Transparent |
| Experimental Example 38 | 54 | Transparent |
| Experimental Example 39 | 55 | Transparent |
| Experimental Example 40 | 56 | Transparent |
| Experimental Example 41 | 54 | Transparent |
| Experimental Example 42 | 53 | Transparent |
| Experimental Example 43 | 55 | Transparent |
| Experimental Example 44 | 54 | Transparent |
| Experimental Example 45 | 53 | Transparent |
| Experimental Example 46 | 54 | Transparent |
| Experimental Example 47 | 52 | Transparent |
| Experimental Example 48 | 52 | Transparent |
| Experimental Example 49 | 54 | Transparent |
| Experimental Example 50 | 52 | Transparent |
| Comparative Experimental Example 1 | 31 | Transparent |
| Comparative Experimental Example 2 | 40 | Transparent |
| Comparative Experimental Example 3 | 40 | Transparent |
| Comparative Experimental Example 4 | 40 | Transparent |
| Comparative Experimental Example 5 | 39 | Transparent |
| Comparative Experimental Example 6 | 38 | Transparent |
| Comparative Experimental Example 7 | 38 | Transparent |
| Comparative Experimental Example 8 | 37 | Transparent |
| Comparative Experimental Example 9 | 37 | Transparent |
| Comparative Experimental Example 10 | 36 | Transparent |
| Comparative Experimental Example 11 | 36 | Transparent |

**TABLE 26**

| | Number of blocks with no pattern lifting defect | Transparency |
|---|---|---|
| Experimental Example 51 | 58 | Transparent |
| Experimental Example 52 | 58 | Transparent |
| Experimental Example 53 | 57 | Transparent |
| Experimental Example 54 | 57 | Transparent |
| Experimental Example 55 | 57 | Transparent |
| Experimental Example 56 | 56 | Transparent |
| Experimental Example 57 | 55 | Transparent |
| Experimental Example 58 | 55 | Transparent |
| Experimental Example 59 | 54 | Transparent |
| Experimental Example 60 | 53 | Transparent |
| Experimental Example 61 | 57 | Transparent |
| Experimental Example 62 | 57 | Transparent |
| Experimental Example 63 | 57 | Transparent |
| Experimental Example 64 | 56 | Transparent |
| Experimental Example 65 | 56 | Transparent |
| Experimental Example 66 | 56 | Transparent |
| Experimental Example 67 | 55 | Transparent |
| Experimental Example 68 | 54 | Transparent |
| Experimental Example 69 | 54 | Transparent |
| Experimental Example 70 | 53 | Transparent |
| Experimental Example 71 | 57 | Transparent |
| Experimental Example 72 | 58 | Transparent |
| Experimental Example 73 | 56 | Transparent |
| Experimental Example 74 | 57 | Transparent |
| Experimental Example 75 | 58 | Transparent |
| Experimental Example 76 | 56 | Transparent |
| Experimental Example 77 | 56 | Transparent |
| Experimental Example 78 | 57 | Transparent |
| Experimental Example 79 | 55 | Transparent |
| Experimental Example 80 | 56 | Transparent |
| Experimental Example 81 | 57 | Transparent |
| Experimental Example 82 | 55 | Transparent |
| Experimental Example 83 | 56 | Transparent |
| Experimental Example 84 | 57 | Transparent |
| Experimental Example 85 | 54 | Transparent |
| Experimental Example 86 | 55 | Transparent |
| Experimental Example 87 | 56 | Transparent |
| Experimental Example 88 | 53 | Transparent |
| Experimental Example 89 | 54 | Transparent |
| Experimental Example 90 | 55 | Transparent |
| Experimental Example 91 | 53 | Transparent |
| Experimental Example 92 | 53 | Transparent |
| Experimental Example 93 | 55 | Transparent |
| Experimental Example 94 | 53 | Transparent |
| Experimental Example 95 | 52 | Transparent |
| Experimental Example 96 | 54 | Transparent |
| Experimental Example 97 | 52 | Transparent |
| Experimental Example 98 | 52 | Transparent |
| Experimental Example 99 | 53 | Transparent |
| Experimental Example 100 | 51 | Transparent |
| Comparative Experimental Example 1 | 31 | Transparent |
| Comparative Experimental Example 12 | 40 | Transparent |
| Comparative Experimental Example 13 | 40 | Transparent |
| Comparative Experimental Example 14 | 39 | Transparent |
| Comparative Experimental Example 15 | 39 | Transparent |
| Comparative Experimental Example 16 | 38 | Transparent |
| Comparative Experimental Example 17 | 37 | Transparent |
| Comparative Experimental Example 18 | 37 | Transparent |
| Comparative Experimental Example 19 | 36 | Transparent |
| Comparative Experimental Example 20 | 36 | Transparent |
| Comparative Experimental Example 21 | 35 | Transparent |

From the comparison of Experimental Examples 1 to 100 with Comparative Experimental Examples 1 to 21 on the basis of the result of a long-term study, it was found that when the number of blocks with no pattern collapse was equal to or larger than 50 among a total of 89 blocks, a good result was obtained.

In the cases of using rinse solution compositions described below, among the rinse solution compositions corresponding to Experimental Examples 1 to 100,, in was confirmed that the pattern lifting defects were desirably reduced compared to Comparative Experimental Examples 1 to 21. The used rinse solution compositions included: 0.0001 to 0.01 wt% of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, and perfluorianted sulfonate; 0.0001 to 0.5 wt% of a pattern reinforcing agent which is a compound of Formula (1), a compound of Formula (2), or a mixture thereof; 0.0001 to 0.5 wt% of a triol derivative and a tetraol derivative alone, or a mixture thereof, in which the triol derivative is a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the tetraol derivative is a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof; and 98.99 to 99.9997 wt% of water.

In addition, in the cases of using rinse solution compositions described below, among the rinse solution compositions corresponding to Experimental Examples 1 to 100, it was confirmed that the effect of reducing pattern lifting defects was more desirably increased compared to Comparative Experimental Examples 1 to 21. The used rinse solution compositions included: 0.0001 to 0.01 wt% of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, and perfluorianted sulfonate; 0.001 to 0.5 wt% of a pattern reinforcing agent which is a compound of Formula (1), a compound of Formula (2), or a mixture thereof; 0.0001 to 0.5 wt% of a triol derivative and a tetraol derivative alone, or a mixture thereof, in which the triol derivative is a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the tetraol derivative is a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof; and 98.99 to 99.9988 wt% of water.

In addition, in the cases of using rinse solution compositions described below, among the rinse solution compositions corresponding to Experimental Examples 1 to 100, it was confirmed that the effect of reducing pattern lifting defects was much more desirably increased compared to Comparative Experimental Examples 1 to 21. The used rinse solution compositions included: 0.0001 to 0.01 wt% of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, and perfluorianted sulfonate; 0.01 to 0.5 wt% of a pattern reinforcing agent which is a compound of Formula (1), a compound of Formula (2), or a mixture thereof; 0.0001 to 0.5 wt% of a triol derivative and a tetraol derivative alone, or a mixture thereof, in which the triol derivative is a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the tetraol derivative is a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof; and 98.99 to 99.9898 wt% of water.

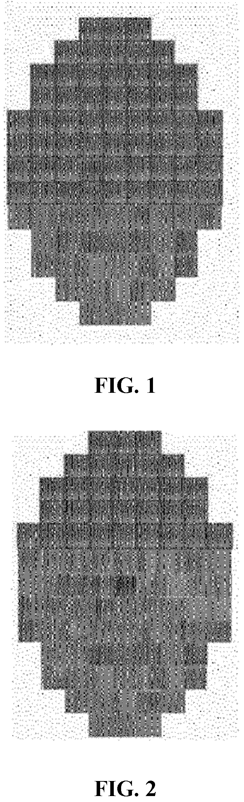

As shown in FIG. 1, the result of evaluating the collapse level of the photoresist pattern formed according to Example 1 was that the number of sections (blocks) where pattern collapse did not occur was measured to be 58, thereby having exhibited the best effect.

As shown in FIG. 2, the result of evaluating the collapse level of the photoresist pattern formed according to Comparative Experimental Example 1 was that the number of sections (blocks) where pattern collapse did not occur was measured to be 31.

Although the specific aspects of the present disclosure have been disclosed in detail above, it will be apparent to those skilled in the art to which the present disclosure pertains that this specific description is merely of preferable exemplary embodiments and is not to be construed to limit the scope of the present disclosure. Therefore, the substantial scope of the present disclosure will be defined by the appended claims and equivalents thereof.

## Claims

1. A rinse solution composition for extreme ultraviolet photolithography, the rinse solution composition comprising:
a fluorine-based surfactant;
a pattern reinforcing agent which is a compound of Formula (1), a compound of Formula (2), or a mixture thereof;
a substance selected from the group consisting of a triol derivative, a tetraol derivative, and a mixture thereof; and
a residual amount of water, 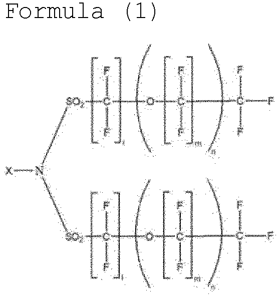
wherein, in Formula (1) above,
X is fluorine, hydrogen, or C₁ to C₅ alkyl,
X forms a single bond,
l is in a range of 1 to 4, and m and n are in a range of 1 to 3, 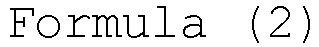 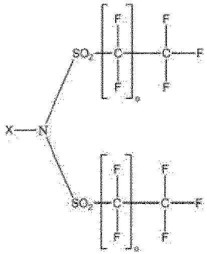
wherein, in Formula (2) above,
X is fluorine, hydrogen, or C₁ to C₅ alkyl,
X forms a single bond, and
O is in a range of 0 to **2.**

2. The rinse solution composition of claim 1, comprising:
0.0001 to 0.01 wt% of a fluorine-based surfactant;
0.0001 to 0.5 wt% of a pattern reinforcing agent which is a compound of Formula (1), a compound of Formula (2), or a mixture thereof;
0.0001 to 0.5 wt% of a substance selected from the group consisting of a triol derivative, a tetraol derivative, and a mixture thereof; and
a residual amount of water,

3. The rinse solution composition of claim 2, comprising:
0.0001 to 0.01 wt% of a fluorine-based surfactant;
0.001 to 0.5 wt% of a pattern reinforcing agent which is a compound of Formula (1), a compound of Formula (2), or a mixture thereof;
0.0001 to 0.5 wt% of a substance selected from the group consisting of a triol derivative, a tetraol derivative, and a mixture thereof; and
a residual amount of water,

4. The rinse solution composition of claim 2, wherein the fluorine-based surfactant is selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorianted sulfonate, and mixtures thereof.

5. The rinse solution composition of claim 2, wherein the triol derivative is a C₃ to C₁₀ triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and wherein the tetraol derivative is a C₄ to C₁₄ tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethyl-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

6. A method of forming a photoresist pattern, the method comprising:
(a) applying a photoresist to a semiconductor substrate to form a film;
(b) exposing the photoresist film and then developing the photoresist film to form a pattern; and
(c) cleaning the photoresist pattern with the rinse solution composition of any one of claims 1 to 5.
